# EUROPEAN PATENT APPLICATION

(11) **EP 1 885 168 A1**
(43) Date of publication of application: **06.02.2008**
(21) Application number: 06746784.5
(22) Date of filing: 24.05.2006
(51) Int. Cl.: H05K 1/14, H01L 21/60, H01L 25/16, H05K 3/36

(54) **CIRCUIT SUBSTRATE CONNECTION STRUCTURE AND CIRCUIT SUBSTRATE CONNECTION METHOD**

(30) Priority: 25.05.2005 JP 2005152386
(71) Applicant: MATSUSHITA ELECTRIC INDUSTRIAL CO., LTD., Osaka 571-8501 (JP)
(72) Inventor: SUZUKI, Hiroyuki, c/o Matsushita Electric Industrial Co., Ltd, 2-1-61, Shitomi, Chuo-ku, Osaka 540-6207 (JP)
(74) Representative: Grünecker, Kinkeldey, Stockmair & Schwanhäusser Anwaltssozietät
(86) International application number: PCT/JP2006/310351
(87) International publication number: WO 2006/126586

(57) **Abstract**

A circuit board connection structure and a circuit board connection method, which can extend an area for mounting electronic components and can simplify the manufacturing process, are provided.

A circuit board connection structure 30 includes: a reverse face circuit pattern 43 (see Fig. 3), prepared on a reverse face 32B of a first circuit board 31; and a first electronic component 45 and a second electronic component 46, mounted on the reverse face circuit pattern 43. According to this circuit board connection method, during a process for connecting the first and second circuit boards 31 and 35, a pressing jig 55, which includes first and second contact faces 56 and 57 that respectively contact top portions 45A and 46A of the first and second electronic components 45 and 46 and a receiving face 58, which contacts a receiving face 51 and is parallel to the first circuit board 31, is arranged between the top portions 45Aand 46Aof the first and second electronic components 45 and 46 and the receiving base 51.

## Description

### <Technical Field>

The present invention relates to a circuit board connection structure wherein a first circuit board and a second circuit board are connected using a heat pressure adhesive, and a circuit board connection method.

### <Background Art>

For an electronic apparatus such as a mobile phone, reductions in the size, thickness and weight of a case are desired, and a flexible board wherein a circuit pattern is formed along a soft substrate is frequently employed as a circuit board that is accommodated in a case.

When a connector is employed for the connection of flexible boards, the housing of the connector becomes a factor that prevents reductions in the size, thickness and weight of a case.

Therefore, a circuit board connection structure is frequently employed wherein individual flexible boards are laminated, so that the connection faces provided for the two circuit patterns are positioned opposite each other, and wherein a heat and pressure adhesive is applied between the individual connection faces and the flexible boards are pressed together, in the direction of their thicknesses, and are also heated and connected together by joints (for example, patent document 1) .
Patent document 1: JP2003-A-249734

### <Disclosure of the Invention>

### <Problems that the Invention is to Solve>

According to patent document 1, to connect a pair of flexible boards, a dummy pattern is formed in advance on a reverse face that corresponds to the connection face of one of the flexible boards, and deformation of the flexible boards is prevented when the individual joints are subjected to pressure.

In such a circuit board connection structure, since the individual flexible boards are subjected to pressure, in the direction of their thicknesses, and are also heated, electronic components are not mounted on a dummy pattern.

Recently, since the level of the demand for electronic apparatuses has increased, smaller circuit boards are being adopted, compared with conventional usage.

That is, since the dimensions of recent circuit boards on which electronic components can be mounted are gradually being reduced, extension of the portions on which electronic components can be mounted is required.

A portion whereon mounting space for electronic components is available can be the reverse face of each circuit board. However, the mounting of electronic components on the reverse face of each circuit board must be performed after a connection process associated with the application of pressure and heat has been completed, and the manufacturing process would be complicated.
Therefore, a circuit board connection structure and a circuit board connection method have been requested, so that the process used to connect the individual circuit boards can be performed in a state wherein electronic components are mounted on the reverse face.

The present invention provides a circuit board connection structure and a circuit board connection method, so that areas wherein electronic components can be mounted can be extended and the manufacturing process can be simplified.

### <Means for Solving the Problems>

A circuit board connection structure according to the present invention, which includes
a first circuit board and a second circuit board, for which circuit patterns are provided on obverse faces of substrates formed as planes,
a first connection face, provided for an obverse face circuit pattern on the first circuit board
a second connection face, provided for an obverse face circuit pattern on the second circuit board, and
an adhesive, applied between the first connection face and the second connection face, and
wherein the first circuit board and the second circuit board are connected, in the direction of their thicknesses, is characterized by comprising:
a reverse face circuit pattern, formed on a reverse face of the first circuit board;
an electronic component mounted on the reverse face circuit pattern; and
a molded portion, for covering the electronic component.

The reverse face circuit pattern is provided for the reverse face of the first circuit board, and electronic components are mounted on the reverse face circuit pattern.

The reverse face of the first circuit board is the portion on the reverse side of a joint, and since the reverse side of the joint is employed as a portion for mounting electronic components, the area for mounting electronic components can be extended.

Therefore, electronic components can be satisfactorily mounted on a reverse face circuit pattern having a larger mounting dimension.

In addition, a molded portion that covers the electronic components is prepared. Therefore, when electronic components having different heights are mounted on the reverse face circuit pattern, the obverse face of the molded portion can be flat and parallel to the first circuit board.

By using the obverse face of the molded portion, the first circuit board and the second circuit board can be pressed together, in the direction of their thicknesses, and can also be heated.

Thus, in a state wherein electronic components are mounted on the reverse face of the first circuit board, the process for connecting the first circuit board to the second circuit board can be performed, so that the manufacturing process can be simplified.

Furthermore, a circuit board connection structure according to the present invention, which includes
a first circuit board and a second circuit board, for which circuit patterns are provided on obverse faces of substrates formed as planes,
a first connection face, provided for an obverse face circuit pattern on the first circuit board
a second connection face, provided for an obverse face circuit pattern on the second circuit board, and
an adhesive, applied between the first connection face and the second connection face, and
wherein the first circuit board and the second circuit board are connected, in the direction of their thicknesses, is characterized:
by comprising a reverse face circuit pattern, provided for a reverse face of the first circuit board, and a plurality of electronic components, mounted on the reverse circuit pattern; and
by arranging top portions of the electronic components along the same parallel plane relative to the first circuit board.

The reverse face circuit pattern is provided for the reverse face of the first circuit board, and electronic components are mounted on the reverse face circuit pattern.

The reverse face of the first circuit board is the portion on the reverse side of a joint, and since the reverse side of the joint is employed as a portion for mounting electronic components, the area for mounting electronic components can be extended.

Therefore, electronic components can be satisfactorily mounted on a reverse face circuit pattern having a larger mounting dimension.

Moreover, the top portions of a plurality of electronic components are arranged along the same parallel plane relative to the first circuit board. Thus, after electronic components are mounted on the reverse face circuit pattern, the top portions of the individual electronic components can be employed to press the first and second circuit boards together, in the direction of their thicknesses, and also to heat them.

Thus, in a state wherein electronic components are mounted on the reverse face of the first circuit board, the process for connecting the first circuit board to the second circuit board can be performed, so that the manufacturing process can be simplified.

Additionally, a circuit board connection structure according to the present invention, which includes
a first circuit board and a second circuit board, for which circuit patterns are provided on obverse faces of substrates formed as planes,
a first connection face, provided for an obverse face circuit pattern on the first circuit board a second connection face, provided for an obverse face circuit pattern on the second circuit board, and
an adhesive, applied between the first connection face and the second connection face, and
wherein the first circuit board and the second circuit board are connected, in the direction of their thicknesses, is characterized by comprising:
a reverse face circuit pattern, formed on a reverse face of the first circuit board;
an electronic component mounted on the reverse face circuit pattern; and
a member for covering the electronic component by enclosing an empty space.

The reverse face circuit pattern is provided for the reverse face of the first circuit board, and electronic components are mounted on the reverse face circuit pattern.

The reverse face of the first circuit board is the portion on the reverse side of a joint, and since the reverse side of the joint is employed as a portion for mounting electronic components, the area for mounting electronic components can be extended.

Therefore, electronic components can be satisfactorily mounted on a reverse face circuit pattern having a larger mounting dimension.

In addition, the member that covers the electronic components by enclosing the empty space is prepared. Therefore, when electronic components having different heights are mounted on the reverse face circuit pattern, the obverse face of the covering member can be flat and parallel to the first circuit board.

By using the obverse face of the covering member, the first circuit board and the second circuit board can be pressed together, in the direction of their thicknesses, and can also be heated.

Thus, in a state wherein electronic components are mounted on the reverse face of the first circuit board, the process for connecting the first circuit board to the second circuit board can be performed, so that the manufacturing process can be simplified.

And the circuit board connection structure of the present invention is characterized in that the adhesive is an anisotropic conductive adhesive containing conductive particles.

Furthermore, a circuit board connection method according to the present invention, for which are provided
a first circuit board and a second circuit board, for which circuit patterns are provided on obverse faces of substrates formed as planes,
a first connection face, provided for an obverse face circuit pattern on the first circuit board a second connection face, provided for an obverse face circuit pattern on the second circuit board, and
an adhesive, applied between the first connection face and the second connection face, and
whereby the first circuit board and the second circuit board are connected, in the direction of their thicknesses,
is characterized by:
mounting a plurality of electronic components on a reverse face circuit pattern, provided on a reverse face of the first circuit board; and
to perform the connection process, arranging, between a top portion of each of the electronic components and a pressing mold, a jig that includes a plurality of contact faces that individually contact the top portions of the electronic component and a receiving face that contacts the pressure die and is parallel to the first circuit board.

The reverse face circuit pattern is provided for the reverse face of the first circuit board, and electronic components are mounted on the reverse face circuit pattern.

The reverse face of the first circuit board is the portion on the reverse side of a joint, and since the reverse side of the joint is employed as a portion for mounting electronic components, the area for mounting electronic components can be extended.

Therefore, electronic components can be satisfactorily mounted on a reverse face circuit pattern having a larger mounting dimension.

Moreover, to perform the connection process, the jig is arranged between the top portion of each electronic component and the pressure die. This jig includes a plurality of contact faces, which individually contact the top portion of each electronic component, and a receiving face, which contacts the pressure die and is parallel to the first circuit board.

Thus, when the receiving face of the jig is placed on the pressure die and the top portion of each electronic component are settled on the individual contact faces of the jig, the first circuit board can be arranged parallel to the pressure die.

Therefore, by using the pressure die, the first and second circuit boards can be pressed together, in the direction of their thicknesses, and can be heated.

Thus, in a state wherein electronic components are mounted on the reverse face of the first circuit board, the process for connecting the first circuit board to the second circuit board can be performed, so that the manufacturing process can be simplified.

Furthermore, a circuit board connection method according to the present invention, for which are provided
a first circuit board and a second circuit board, for which circuit patterns are provided on obverse faces of substrates formed as planes,
a first connection face, provided for an obverse face circuit pattern on the first circuit board a second connection face, provided for an obverse face circuit pattern on the second circuit board, and
an adhesive, applied between the first connection face and the second connection face, and whereby the first circuit board and the second circuit board are connected, in the direction of their thicknesses,
is characterized in that:
a plurality of electronic components are mounted on a reverse face circuit pattern, formed on a reverse face of the first circuit board, and thereafter, are covered by molding.

The reverse face circuit pattern is provided for the reverse face of the first circuit board, and electronic components are mounted on the reverse face circuit pattern.

The reverse face of the first circuit board is the portion on the reverse side of a joint, and since the reverse side of the joint is employed as a portion for mounting electronic components, the area for mounting electronic components can be extended.

Therefore, electronic components can be satisfactorily mounted on a reverse face circuit pattern having a larger mounting dimension.

In addition, a plurality of electronic components are mounted, and thereafter, these electronic components are covered by the molded portion. Therefore, when electronic components having different heights are mounted on the reverse face circuit pattern, the obverse face of the molded portion can be flat and parallel to the first circuit board.

By using the obverse face of the molded portion, the first circuit board and the second circuit board canbe pressed together, in the direction of their thicknesses, and can also be heated.

Thus, in a state wherein electronic components are mounted on the reverse face of the first circuit board, the process for connecting the first circuit board to the second circuit board can be performed, so that the manufacturing process can be simplified.

Furthermore, a circuit board connection method according to the present invention, for which are provided
a first circuit board and a second circuit board, for which circuit patterns are provided on obverse faces of substrates formed as planes,
a first connection face, provided for an obverse face circuit pattern on the first circuit board a second connection face, provided for an obverse face circuit pattern on the second circuit board, and
an adhesive, applied between the first connection face and the second connection face, and whereby the first circuit board and the second circuit board are connected, in the direction of their thicknesses,
is characterized in that:
a plurality of electronic components, top portions of which are arranged along the same parallel plane relative to the first circuit board, are mounted on a reverse face circuit pattern, provided for a reverse face of the first circuit board.

The reverse face circuit pattern is provided for the reverse face of the first circuit board, and electronic components are mounted on the reverse face circuit pattern.

The reverse face of the first circuit board is the portion on the reverse side of a joint, and since the reverse side of the joint is employed as a portion for mounting electronic components, the area for mounting electronic components can be extended.

Therefore, electronic components can be satisfactorily mounted on a reverse face circuit pattern having a larger mounting dimension.
Moreover, for mount ing a plurality of electronic components, the top portions of these electronic components are arranged along the same parallel plane relative to the first circuit board. Thus, after electronic components are mounted on the reverse face circuit pattern, the top portions of the individual electronic components can be employed to press the first and second circuit boards together, in the direction of their thicknesses, and also to heat them.

Thus, in a state wherein electronic components are mounted on the reverse face of the first circuit board, the process for connecting the first circuit board to the second circuit board can be performed, so that the manufacturing process can be simplified.

Furthermore, a circuit board connection method according to the present invention, for which are provided
a first circuit board and a second circuit board, for which circuit patterns are provided on obverse faces of substrates formed as planes,
a first connection face, provided for an obverse face circuit pattern on the first circuit board
a second connection face, provided for an obverse face circuit pattern on the second circuit board, and
an adhesive, applied between the first connection face and the second connection face, and
whereby the first circuit board and the second circuit board are connected, in the direction of their thicknesses,
is characterized in that:
a plurality of electronic components are mounted on a reverse face circuit pattern, formed on a reverse face of the first circuit board; and
thereafter, a member for covering the electronic component by enclosing an empty space is attached.

The reverse face circuit pattern is provided for the reverse face of the first circuit board, and electronic components are mounted on the reverse face circuit pattern.

The reverse face of the first circuit board is the portion on the reverse side of a joint, and since the reverse side of the joint is employed as a portion for mounting electronic components, the area for mounting electronic components can be extended.

Therefore, electronic components can be satisfactorily mounted on a reverse face circuit pattern having a larger mounting dimension.

In addition, after electronic components are mounted, the member that covers the electronic components by enclosing the empty space is attached. Therefore, when electronic components having different heights are mounted on the reverse face circuit pattern, the obverse face of the covering member can be flat and parallel to the first circuit board.

By using the obverse face of the covering member, the first circuit board and the second circuit board can be pressed together, in the direction of their thicknesses, and can also be heated.

Thus, in a state wherein electronic components are mounted on the reverse face of the first circuit board, the process for connecting the first circuit board to the second circuit board can be performed, so that the manufacturing process can be simplified.

And the circuit board connection method of the present invention is characterized in that the adhesive is an anisotropic conductive adhesive containing conductive particles.

Further, an electronic apparatus according to this invention is characterized by employing one of the above described circuit board connection structures.

### <Advantages of the Invention>

According to the present invention, since the reverse side of the j oint is employed as a portion for mounting electronic components, the dimensions for mounting electronic components are extended, and effects such that electronic components can be appropriately mounted can be provided.

Additionally, according to the present invention, in a state wherein electronic components are mounted on the reverse face of the first circuit board, the process for connecting the first circuit board and the second circuit board can be performed. Thus, such effects as that the manufacturing process can be simplified can be obtained.

### <Brief Description of the Drawings>

Fig. 1 is a perspective view showing an electronic apparatus according to a first mode of the present invention.
Fig. 2 is a perspective view showing a connection structure for circuit boards according to the first mode.
Fig. 3 is a diagram for explaining a circuit board connection structure and a circuit board connection method according to the first mode.
Fig. 4 is a diagram for explaining a circuit board connection structure and a circuit board connection method according to a second mode.
Fig. 5 is a diagram for explaining a circuit board connection structure and a circuit board connection method according to a third mode.
Fig. 6 is a diagram for explaining a circuit board connection structure and a circuit board connection method according to a fourth mode.
Fig. 7 is a diagram for explaining a circuit board connection structure and a circuit board connection method according to a fifth mode.
Fig. 8 is a diagram for explaining a circuit board connection structure and a circuit board connection method according to a sixth mode.

### <Description of Reference Numerals and Signs>

10: electronic apparatus
30, 60, 70, 80, 90, 100 : circuit board connection structure
31: first circuit board (circuit board)
32, 36: substrate
32A, 36A: obverse face of a substrate
32B, 36B: reverse face of a substrate
33, 37: obverse face circuit pattern (circuit pattern)
34: first connection face
35: second circuit board (circuit board)
38: second connection face
40: anisotropic conductive adhesive (heat and pressure adhesive)
41: joint
43: reverse face circuit pattern (circuit pattern)
45, 46: electronic component
45A, 46A: top portion of an electronic component
50: pressing mold
51: base
55: pressing jig (jig)
56, 57: first and second contact face (a plurality of contact faces)
58: receiving face
61: molded portion
81: molded member

### <Best Modes for Carrying Out the Invention>

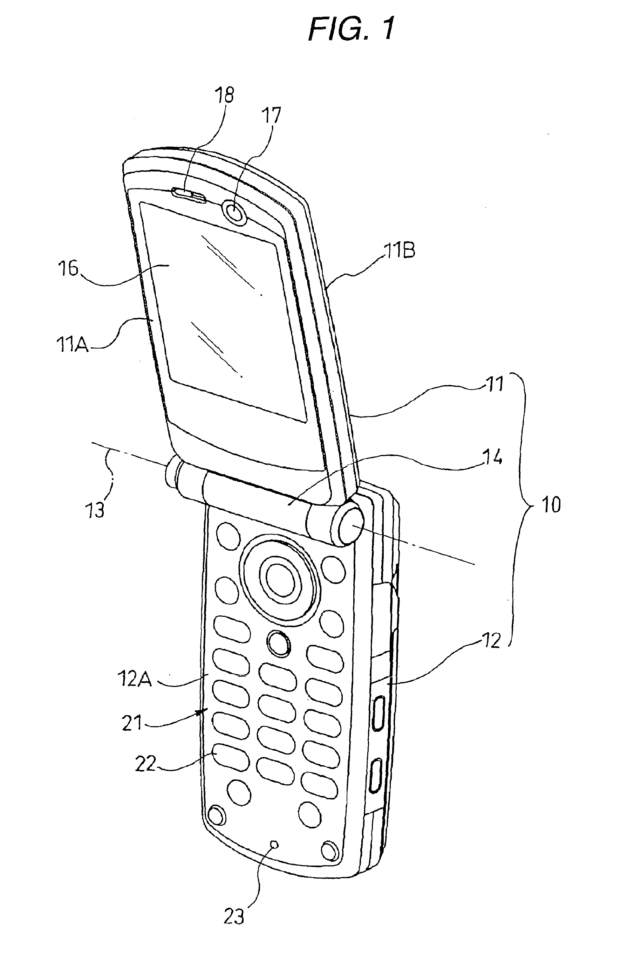

As shown in Fig. 1, an electronic apparatus 10 according to a first mode is a mobile telephone that includes: an upper case 11 anda lower case 12; a couplingportion 14, whichpivotally couples the upper case 11 and the lower case 12 at a rotary axis 13 that is located along the boundary line between the upper case 11 and the lower case 12; and a circuit board connection structure 30, which is stored in the upper and lower cases to electrically connect the individual devices.

A display portion 16 is located substantially in the center of an obverse face 11A of the upper case 11, a self photographing camera 17 and a receiver 18 are located above the display portion 16, and a companion site photographing camera (not shown) is located on a reverse face 11B.

As for the lower case 12, keys 22 in an operating unit 21 are arranged substantially in the center of an obverse face 12A, and a microphone 23 is located below the operating unit 21.

The coupling portion 14 pivotally supports the lower end of the upper case 11 with the upper end of the lower case 12.

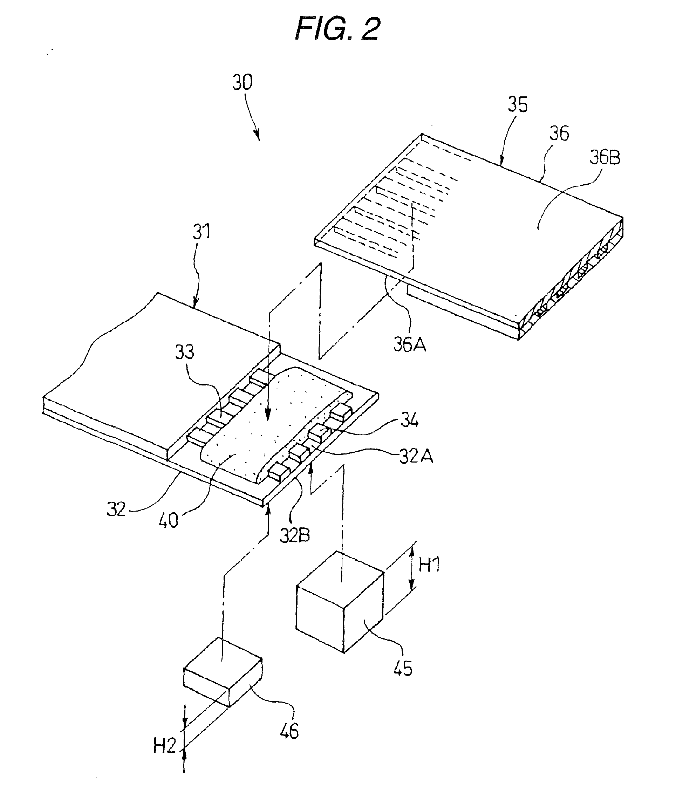

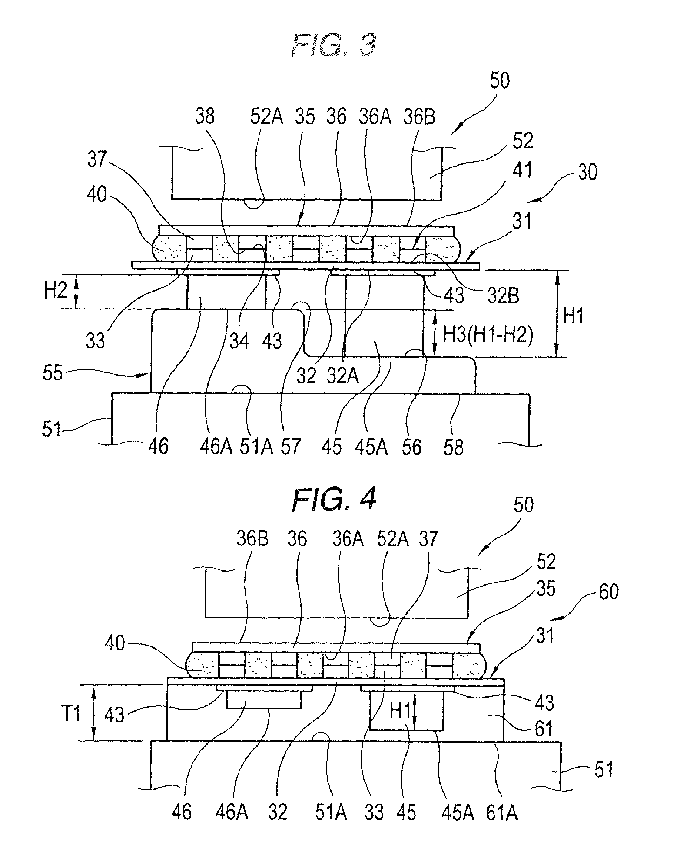

As shown in Fig. 2, the circuit board connection structure 30 of the first mode includes: a first circuit board 31, wherein an obverse face circuit pattern (circuit pattern) 33 is formed on an obverse face 32A of a substrate 32 formed as a plane; a second circuit board 35, wherein an obverse face circuit pattern (circuit pattern) 37 (Fig. 3) is formed on an obverse face 36A of a substrate 36 formed as a plane; a first connection face 34, prepared for the obverse circuit pattern 33 of the first circuit board 31, and a second connection face 38 (Fig. 3), prepared for the obverse circuit pattern 37 of the second circuit board 35; an anisotropic conductive adhesive 40, which is a heat and pressure adhesive located between the first connection face 34 and the second connection face 38; and joints 41 (Fig. 3), formed through a connection process during which the first circuit board 31 and the second circuit board 35 are pressed together, in the direction of their thicknesses, and are heated.

This circuit board connection structure 30 includes: a reverse face circuit pattern 43 (see Fig. 3), which is prepared on a reverse face 32B of the first circuit board 31; and first and second electronic components (a plurality of electronic components) 45 and 46, which are mounted on the reverse face circuit pattern 43.

The reverse circuit pattern 43 is formed on the reverse face 32B of the first circuit board 31, and the first electronic component 45 and the second electronic component 46 are mounted on the reverse face circuit pattern 43.

The reverse face 32B of the first circuit board 31 is the portion on the reverse side of the joints 41, and when the reverse side of the joints 41 is employed as the portion for mounting the electronic components 45 and 46, the mounting area for the first electronic component 45 and the second electronic component 46 is increased.

Therefore, the first electronic component 45 and the second electronic component 46 can be appropriately mounted on the reverse face circuit pattern 43 for which the mounting area is increased.

The first circuit board is a flexible board that includes: the soft substrate 32, formed as a plane; the obverse face circuit pattern 33, formed along the obverse face 32A of the substrate 32; the reverse face circuit pattern 43, formed on the reverse face 32B of the substrate 32 and externally exposed; and the anisotropic conductive adhesive 40, applied at the predetermined position (i.e., the first connection face) 34 on the obverse face circuit pattern 33.

The second circuit board 35 is a flexible board that includes: the soft substrate 36, formed as a plane; the obverse face circuit pattern 37, formed along the obverse face 36A of the substrate 36; and a reverse face circuit pattern 39, formed on the reverse face 36B of the substrate 36.

The anisotropic conductive adhesive 40, which is a heat and pressure adhesive, contains as a base resin element an epoxy resin, an acrylic resin, an imide resin or a silicon resin of a thermosetting type, and is used in a paste state or a B stage state.

The characteristics of this resin are extremely low ion contamination (order of several ppm) and high heat resistance.

The anisotropic conductive adhesive 40 is maintained in a state wherein a specific amount (5 to 20 wt%) of conductive particles are not coagulated but are dispersed.

Furthermore, as the adhesive setting property of the anisotropic conductive adhesive 40, the elastic modulus is about 1 to 2 GPa, and the linear expansion coefficient is 20 to 60 ppm/°C at 40 to 100°C.

The first electronic component 45 has a top portion 45A, and the second electronic component 46 has a top portion 46A. The top portions 45A and 46A are formed parallel to the substrate 32 of the first circuit board 31.

In this case, the height of the first electronic component 45 is H1, while the height of the second electronic component 46 is H2. The height H1 is greater than the height H2.

That is, the top portion 45A of the first electronic component 45 is positioned lower a distance (H1 - H2) than the top portion 46A of the second electronic component 46.

A circuit board connection method for the first mode will now be explained while referring to Fig. 3.

First, the first electronic component 45 and the second electronic component 46 are mounted and soldered, on the reverse face circuit pattern 43 that is formed on the reverse face 32B of the first circuit board 31.

Next, a pressing jig (jig) 55 is mounted on a receiving base 51 of a pressing mold 50.

This pressing mold 50 includes: the receiving base 51, below the first and second circuit boards 31 and 35, and a bonding heater head 52, above the first and second circuit boards 31 and 35.

The receiving base 51 has an obverse face 51A for supporting the first and the second circuit boards 31 and 35.

The bonding heater head 52 has a lower face 52A, which is located above the first and second circuit boards 31 and 35 and is parallel to the obverse face 51A of the receiving base 51.

Furthermore, the pressing jig 55 includes: first and second contact faces (a plurality of contact faces) 56 and 57, which respectively contact the top portions 45A and 46A of the first electronic component 45 and the second electronic component 46; and a receiving face 58, which contacts the obverse face 51A of the receiving base 51 and is parallel to the first circuit board 31.

The first contact face 56 is formed lower by height H3 than the second contact face 57. The height H3 is (H1 - H2).

The first and second contact faces 56 and 57 are those parallel to the first circuit board.

The top portion 45A of the first electronic component 45 is settled on the first contact face of the pressing jig 55, and the top portion 46A of the second electronic component 46 is settled on the second contact face 57.

Thus, the pressing jig 55 is arranged between the top portions 45A and 46A of the first and second electronic components 45 and 46 and the receiving base 51.

At this time, since the first contact face 56 is lower by (H1-H2) than the second contact face 57, the first circuit board 31 (i.e., the substrate 32 and the obverse face circuit pattern 33) can be arranged parallel to the obverse face 51A of the receiving base 51.

In addition, the first circuit board 31 (i.e., the substrate 32 and the obverse face circuit pattern 33) can be arranged parallel to the lower face 52A of the bonding heater head 52.

The anisotropic conductive adhesive 40, of a gel type, is applied to the first connection face 34, of the obverse face circuit pattern 33, that is externally exposed.

The second circuit board 35 is mounted on the applied anisotropic conductive adhesive 40.

Specifically, for the obverse face circuit pattern 37 of the second circuit board 35, the second connection face 38, which is externally exposed, is placed on the anisotropic conductive adhesive 40 and is aligned with the first connection face 34.

At this time, since the first circuit board 31 (i.e., the substrate 32 and the obverse face circuit pattern 33) is arranged parallel to the lower face 52A of the bonding heater head 52, the reverse face 36B of the second circuit board 35 is positioned parallel to the lower face 52A of the bonding heater head 52.

Next, the bonding heater head 52 is placed on the reverse face 36B of the second circuit board 35.

Sequentially, since the bonding heater 52 is heated, the first circuit board 31 and the second circuit board 35 are pressed together, in the direction of their thicknesses, and are also heated.

Thus, in a state wherein the first connection face 34 and the second connection face 38 are connected, the first circuit board 31 and the second circuit board 35 are thermally bonded using the anisotropic conductive adhesive 40.

The first connection face 34 and the second connection face 38 are coupled to serve as the joints 41, and the circuit board connection structure 30, i.e., a multi-layer flexible board, is obtained. Thus, the circuit board connection processing is completed.

According to the circuit board connection method of the first mode, during the processing for connecting the first and the second circuit boards 31 and 35, the pressing jig 55 is arranged between the top portions 45A and 46A of the first and second electronic components 45 and 46 and the base (pressing mold) 51.

This pressing jig 55 includes: the first and second contact faces 56 and 57, which respectively contact the top portions 45A and 46A of the first and the second electronic components 45 and 46; and the receiving face 58, which contacts the receiving base 51 and is parallel to the first circuit board 31.

Therefore, when the receiving face 58 is placed on the receiving base 51 and the top portions 45A and 46A of the first and second electronic components 45 and 46 are settled on the first and second contact faces 56 and 57, the first circuit board 31 can be arranged parallel to the receiving base 51.

As a result, by using the pressing mold 50, the first circuit board 31 and the second circuit board 35 can be pressed together, in the direction of their thicknesses, and can also be heated.

Therefore, in a state wherein the first electronic component 45 and the second electronic component 46 are mounted on the reverse face 32B of the first circuit board 31, the process for connecting the first circuit board 31 to the second circuit board 35 can be performed, so that the manufacturing processing can be simplified.

Second to sixth modes will now be described while referring to Figs. 4 to 7.

It should be noted that in the second to sixth modes the same reference numerals are provided for the same or similar members, and for these members, no further explanation will be given.

### (Second Mode)

As shown in Fig. 4, a circuit board connection structure 60 according to the second mode includes a molded portion 61, which covers a first electronic component 45 and a second electronic component 46, and the remainder of the structure is the same as that for the first mode.

For the molded portion 61, a thickness T1 is equal to or greater than a height H1 of the first electronic component 45, in order to cover the first and second electronic components 45 and 46.

Thus, an obverse face 61A of the molded portion 61 can be formed, flattened, and can be parallel to a first circuit board 31.

As a connection method for the circuit board connection structure 60, the first electronic component 45 and the second electronic component 46 are mounted on a reverse face circuit pattern 43, which is prepared on a reverse face 32B of the first circuit board 31, and are covered thereafter with the molded portion 61.

Therefore, when the heights of the first and second electronic components 45 and 46 mounted on the revere face circuit pattern 43 vary, the obverse face 61A of the molded portion 61 can be flat, and can be parallel to the first circuit board 31.

When the obverse face 61A of the molded portion 61 is employed, the first circuit board 31 and the second circuit board 35 can be pressed together, by a pressing mold 50, in the direction of their thicknesses, and can be heated.

As a result, in a state wherein the first electronic component 45 and the second electronic component 46 are mounted on the reverse face 32B of the first circuit board 31, the process for connecting the first circuit board 31 to the second circuit board 32 can be performed. Thus, the manufacturing processing can be simplified.

Additionally, according to the circuit board connection structure 60 of the second mode, the same effects as are provided by the circuit board connection structure 30 in the first mode can also be obtained.

### (Third Mode)

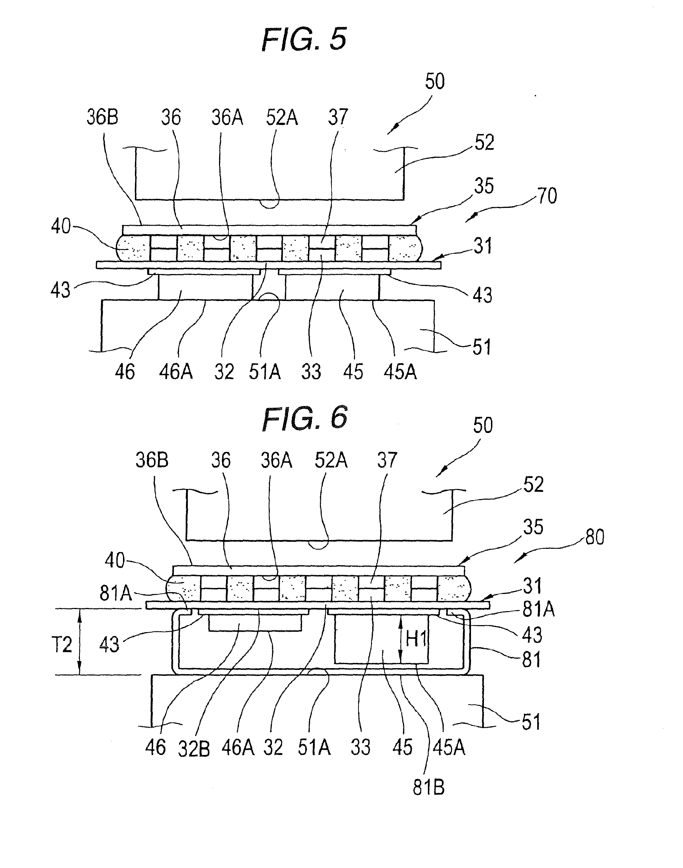

As shown in Fig. 5, for a circuit board connection structure 70 according to a third mode, top portions 45A and 46A of a first electronic component 45 and a second electronic component 46 are arranged along the same parallel face, relative to a first circuit board 31. The remainder of the structure is the same as that for the first mode.

As a connection method for the circuit board connection structure 70, the first and second electronic components 45 and 46, the top portions 45A and 46A, which are arranged along the same parallel face relative to the first circuit board 31, are mounted on a reverse face circuit pattern 43 that is prepared on a reverse face 32B of the first circuit board 31.

Therefore, after the first and second electronic components 45 and 46 have been mounted on the reverse face circuit pattern 43, by employing the top portions 45A and 46A of the first and second electronic components 45 and 46, the first circuit board 31 and a second circuit board 35 can be pressed together, in the direction of their thicknesses, and can also be heated.

As a result, in a state wherein the first electronic component 45 and the second electronic component 46 are mounted on the reverse face 32B of the first circuit board 31, the process for connecting the first circuit board 31 to the second circuit board 32 can be performed. Thus, the manufacturing processing can be simplified.

In addition, according to the circuit board connection structure 70 of the third mode, the same effects as are provided by the circuit board connection structure 30 in the first mode can also be obtained.

### (Fourth Mode)

As shown in Fig. 6, a circuit board connection structure 80 according to the fourth mode includes a shielding portion 81, which covers a first electronic component 45 and a second electronic component 46 by enclosing an empty space 82, and the remainder of the structure is the same as that for the first mode.

The shielding member 81 is, as an example, a box shaped member, with both ends open, that is prepared by bending a flat plate substantially into a U shape, and by folding both U-shaped ends 81A so they are parallel to an obverse face 81B.

The two ends 81A are attached to a reverse face 32B of a substrate 32, so that the shielding member 81 is mounted on the substrate 32.

For the shielding member 81, a thickness T2 is greater than a height H1 of the first electronic component 45, in order to cover the first and second electronic components 45 and 46.

Thus, an obverse face 81B of the shielding member 81 can be formed, flattened, and can be parallel to a first circuit board 31.

In this state, the obverse face 81B of the shielding member 81 faces an obverse face 51a of a receiving base 51.

As a connection method for the circuit board connection structure 80, the first electronic component 45 and the second electronic component 46 are mounted on a reverse face circuit pattern 43, which is prepared on a reverse face 32B of the first circuit board 31, and thereafter, the shielding member 81 is attached so as to cover the first and second electronic components 45 and 46 and enclose the empty space 82.

Therefore, when the heights of the first and second electronic components 45 and 46 mounted on the revere face circuit pattern 43 vary, the obverse face 81B of the shielding member 81 can be flat, and can be parallel to the first circuit board 31.

When the obverse face 81B of the shielding member 81 is employed, the first circuit board 31 and the second circuit board 35 can be pressed together by a pressing mold 50, in the direction of their thicknesses, and can be heated.

As a result, in a state wherein the first electronic component 45 and the second electronic component 46 are mounted on the reverse face 32B of the first circuit board 31, the process for connecting the first circuit board 31 to the second circuit board 32 can be performed. Thus, the manufacturing process can be simplified.

In addition, according to the circuit board connection structure 80 of the fourth mode, the same effects as are provided by the circuit board connection structure 30 in the first mode can also be obtained.

### (Fifth Mode)

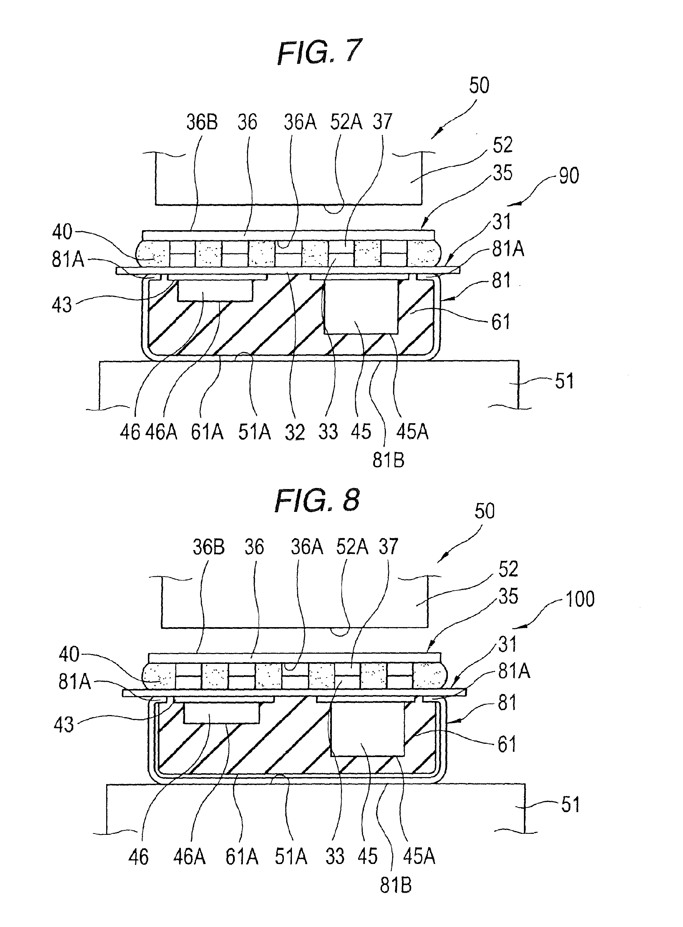

As shown in Fig. 7, a circuit board connection structure 90 according to the fifth mode includes: a shielding portion 81, which covers a first electronic component 45 and a second electronic component 46 by enclosing an empty space 82, and a molded portion 61, which is used to fill the empty space 82. The remainder of the structure is the same as that for the first mode.

As a connection method for the circuit board connection structure 90, after the first electronic component 45 and the second electronic component 46 are mounted on a reverse face circuit pattern 43 that is prepared on a reverse face 32B of the first circuit board 31, the shielding member 81 is attached to cover the first and the second electronic components 45 and 46 and enclose the empty space 82.

Sequentially, the empty space 82 is filled with the molded portion 61 in the melted state, so that the first and the second electronic components 45 and 46 are covered with the molded portion 61.

When, in this manner, the shielding member 81 is attached, and thereafter, the molded portion 61, in the melted state, is used to fill the empty space 82, the molded portion 61 can be provided for the shielding member 81 without leaving any unoccupied space.

According to the circuit board connection structure 90 of the fifth mode, the same effects as are provided by the circuit board connection structure 80 of the fourth mode can be obtained.

In addition, according to the circuit board connection structure 90 of the fifth mode, the same effects as in the first mode are obtained. And since a shielding member is employed as a member for covering an unoccupied space between electronic components, shielding effects for the electronic components can be obtained, and since the interior is filled with a resin, shock resistance for electronic components and component joints, to mitigate the effects of shock when dropped and shock when vibrated, can be obtained.

### (Sixth Mode)

As shown in Fig. 8, a circuit board connection structure 100 for the sixth mode includes: a molded portion 61, which covers a first electronic component 45 and a second electronic component 46; and a shielding member 81, which covers the molded portion 61. The remainder of the other structure is the same as that for the first mode.

As a connection method for the circuit board connection structure 100, after the first electronic component 45 and the second electronic component 46 are mounted on a reverse face circuit pattern 43 that is prepared on a reverse face 32B of the first circuit board 31, the first and the second electronic components 45 are covered with the molded portion 61.

Then, the shielding member 81 that covers the molded portion 61 is attached.

Specifically, the circuit board connection structure 100 of the sixth mode is made in the reverse order of the attachment of the shielding member 81 and the molded portion 61 of the circuit board connection structure 90 of the fifth mode.

According to the circuit board connection structure 100 of the sixth mode, the same effects as are provided for the circuit board connection structure 80 of the fourth mode can be obtained.

In addition, according to the circuit board connection structure 100 of the sixth mode, the same effects as are provided for the fifth mode can be obtained.

It should be noted that in the second mode, and in the fourth to the sixth modes, the two components, i.e., the first and second electronic components 45 and 46, are employed as example multiple electronic components. However, the number of electronic components is not limited to two, and one or three or more components can be mounted.

Furthermore, as examples in the second mode and the fourth to the sixth modes, the top portion 45A of the first electronic component 45 and the top portion 46A of the second electronic component 46 are arranged parallel to the substrate 32 of the first circuit substrate 31. The top portions 45A and 46A may not be parallel to the substrate 32.

Further, the shapes of the pressing jig 55, the molded portion 61 and the shielding member 81 in the individual modes are not limited to those in the examples, and can be changed as needed.

Additionally, the anisotropic conductive adhesive is not a liquid type, and may be a sheet type, and the form thereof is not limited.

Furthermore, in the explanation for the individual modes, the anisotropic conductive adhesive is employed as a heat and pressure adhesive. However, in this invention, a heat and pressure adhesive that does not contain conductive particles may be employed.

Moreover, the first circuit board of this invention may be a flexible board formed, for example, of polyimide, a hard board formed of a glass epoxy resin, etc., and the material or the form is not especially limited.

The present invention is based on Japanese Patent Application (JP-A-2005-152386), filed on May 25, 2005, and the contents thereof are included as a reference in this specification.

### <Industrial Applicability>

The present invention is suitable for application for a circuit board connection structure wherein the first circuit board and the second circuit board are connected using an anisotropic conductive adhesive, and a circuit board connection method therefor.

## Claims

1. A circuit board connection structure, which includes
a first circuit board and a second circuit board, for which circuit patterns are provided on obverse faces of substrates formed as planes,
a first connection face, provided for an obverse face circuit pattern on the first circuit board
a second connection face, provided for an obverse face circuit pattern on the second circuit board, and
an adhesive, applied between the first connection face and the second connection face, and
wherein the first circuit board and the second circuit board are connected, in the direction of their thicknesses, **characterized by** comprising:
a reverse face circuit pattern, formed on a reverse face of the first circuit board;
an electronic component mounted on the reverse face circuit pattern; and
a molded portion, for covering the electronic component.

2. A circuit board connection structure, which includes
a first circuit board and a second circuit board, for which circuit patterns are provided on obverse faces of substrates formed as planes,
a first connection face, provided for an obverse face circuit pattern on the first circuit board
a second connection face, provided for an obverse face circuit pattern on the second circuit board, and
an adhesive, applied between the first connection face and the second connection face, and
wherein the first circuit board and the second circuit board are connected, in the direction of their thicknesses, **characterized:**
**by** comprising a reverse face circuit pattern, provided for a reverse face of the first circuit board, and a plurality of electronic components, mounted on the reverse circuit pattern; and
by arranging top portions of the electronic components along the same parallel plane relative to the first circuit board.

3. A circuit board connection structure, which includes
a first circuit board and a second circuit board, for which circuit patterns are provided on obverse faces of substrates formed as planes,
a first connection face, provided for an obverse face circuit pattern on the first circuit board
a second connection face, provided for an obverse face circuit pattern on the second circuit board, and
an adhesive, applied between the first connection face and the second connection face, and
wherein the first circuit board and the second circuit board are connected, in the direction of their thicknesses, **characterized by** comprising:
a reverse face circuit pattern, formed on a reverse face of the first circuit board;
an electronic component mounted on the reverse face circuit pattern; and
a member for covering the electronic component by enclosing an empty space.

4. A circuit board connection structure according to one of claims 1 to 3, **characterized in that** the adhesive is an anisotropic conductive adhesive containing conductive particles.

5. A circuit board connection method, for which are provided
a first circuit board and a second circuit board, for which circuit patterns are provided on obverse faces of substrates formed as planes,
a first connection face, provided for an obverse face circuit pattern on the first circuit board
a second connection face, provided for an obverse face circuit pattern on the second circuit board, and
an adhesive, applied between the first connection face and the second connection face, and
whereby the first circuit board and the second circuit board are connected, in the direction of their thicknesses,
**characterized by**:
mounting a plurality of electronic components on a reverse face circuit pattern, provided on a reverse face of the first circuit board; and
to perform the connection process, arranging, between a top portion of each of the electronic components and a pressing mold, a jig that includes a plurality of contact faces that individually contact the top portions of the electronic component and a receiving face that contacts the pressure die and is parallel to the first circuit board.

6. A circuit board connection method, for which are provided
a first circuit board and a second circuit board, for which circuit patterns are provided on obverse faces of substrates formed as planes,
a first connection face, provided for an obverse face circuit pattern on the first circuit board
a second connection face, provided for an obverse face circuit pattern on the second circuit board, and
an adhesive, applied between the first connection face and the second connection face, and
whereby the first circuit board and the second circuit board are connected, in the direction of their thicknesses,
is **characterized in that**:
a plurality of electronic components are mounted on a reverse face circuit pattern, formed on a reverse face of the first circuit board, and thereafter, are covered by molding.

7. A circuit board connection method, for which are provided
a first circuit board and a second circuit board, for which circuit patterns are provided on obverse faces of substrates formed as planes,
a first connection face, provided for an obverse face circuit pattern on the first circuit board
a second connection face, provided for an obverse face circuit pattern on the second circuit board, and
an adhesive, applied between the first connection face and the second connection face, and
whereby the first circuit board and the second circuit board are connected, in the direction of their thicknesses,
is **characterized in that**:
a plurality of electronic components, top portions of which are arranged along the same parallel plane relative to the first circuit board, are mounted on a reverse face circuit pattern, provided for a reverse face of the first circuit board.

8. A circuit board connection method, for which are provided
a first circuit board and a second circuit board, for which circuit patterns are provided on obverse faces of substrates formed as planes,
a first connection face, provided for an obverse face circuit pattern on the first circuit board
a second connection face, provided for an obverse face circuit pattern on the second circuit board, and
an adhesive, applied between the first connection face and the second connection face, and
whereby the first circuit board and the second circuit board are connected, in the direction of their thicknesses,
is **characterized in that**:
a plurality of electronic components are mounted on a reverse face circuit pattern, formed on a reverse face of the first circuit board; and
thereafter, a member for covering the electronic component by enclosing an empty space is attached.

9. A circuit board connection method according to one of claims 5 to 8, **characterized in that** the adhesive is an anisotropic conductive adhesive containing conductive particles.

10. An electronic apparatus **characterized by** employing a circuit board connection structure according to one of claims 1 to 3.
